Europäisches Patentamt

European Patent Office

Office européen des brevets

(11) Veröffentlichungsnummer: **0 078 459**
**A1**

## EUROPÄISCHE PATENTANMELDUNG

(21) Anmeldenummer: 82109735.9

(22) Anmeldetag: 21.10.82

(51) Int. Cl.³: **H 05 K 13/00,** H 01 B 3/42

(30) Priorität: 04.11.81 DE 3143814

(43) Veröffentlichungstag der Anmeldung: 11.05.83
**Patentblatt 83/19**

(84) Benannte Vertragsstaaten: **AT CH FR GB IT LI**

(71) Anmelder: **SIEMENS AKTIENGESELLSCHAFT, Berlin und München Wittelsbacherplatz 2, D-8000 München 2 (DE)**

(72) Erfinder: **Burger, Hans-Joachim, Fasanenweg 1, D-8451 Kümmersbruck (DE)**

(54) **Isolierstoffumhüllte Bauteilegruppe.**

(57) Die Erfindung bezieht sich auf eine isolierstoffumhüllte Bauteilegruppe mit elektronischen oder elektrischen Bauteilen.

Die Isolierstoffumhüllung besteht aus der vor reaktiver Aushärtung noch fliessfähiger oder teigartiger, ungesättigter Polyesterharzmasse, deren Temperaturhärteniveau auf ca. 80 °C eingestellt ist. Hierdurch ist es möglich, Bauteilgruppen zu umhüllen, bei denen auch Bauteile Verwendung finden können, die nur mit bei Umhüllung relativ niedrigen Temperaturen belastbar sind.

SIEMENS AKTIENGESELLSCHAFT    Unser Zeichen
Berlin und München            VPA 81 P 3 1 8 7 E

**Isolierstoffumhüllte Bauteilegruppe**

Die Erfindung bezieht sich auf eine isolierstoffumhüllte Bauteilegruppe mit elektronischen oder elektrischen Bauteilen.

Es ist bekannt, hochtemperaturfeste Einzelbauteile wie beispielsweise IC's mit Niederdruckpreßmassen zu umpressen, wobei Härtetemperaturen von 120$^{\circ}$ und höher notwendig sind. Andere elektrische Bauteile, beispielsweise Widerstände, werden getaucht bzw. umgossen mit Lacken oder Gießharzen, die bei Temperaturen aushärten, die höchstens bei 80$^{\circ}$C liegen. Aus diesem Grunde hat man bisher auch Baugruppen lediglich umgossen, da in ihnen im allgemeinen elektrische Bauteile enthalten sind, die Härtetemperaturen von über 80$^{\circ}$C nicht aushalten.

Der Erfindung liegt somit die Aufgabe zugrunde, das Umhüllen auch von Bauteilegruppen möglich zu machen, wobei auf eine genügend große Fließfähigkeit der Harze beim Verpressen zu achten ist, um Verschiebungen der Bauteile zu verhindern.

Dies wird auf einfache Weise bei einer Bauteilegruppe der obengenannten Art dadurch erreicht, daß die Isolierstoffumhüllung aus vor reaktiver Aushärtung aus teigartiger oder noch fließfähiger, ungesättigter Polyesterharz-Preßmasse besteht, deren Temperatur-Härteniveau auf ca. 80$^{\circ}$C eingestellt ist.

La 2 Syr / 27.10.1981

Derartige, z.B. teigartige Polyestermassen sind bereits für die Herstellung von Großteilen wie Karosserien, Stoßstangen, Stühle usw. aus den 50-iger Jahren bekannt, jedoch liegen hier die Härtetemperaturen bei ungefähr 160°C. Das Einstellen der Härtetemperatur auf 80°C bedingt keine großen Schwierigkeiten. Die hochreaktive Einstellung erfordert jedoch eine Anpassung der Transport- und Lagerverhältnisse, d.h. es kann erforderlich sein, die Massen in Tiefkühltransportern zu transportieren und in Tiefkühltruhen bis zur Bearbeitung aufzubewahren, was jedoch ohne Schwierigkeiten möglich ist. Die Verwendung dieser Massen hat jedoch weiterhin den Vorteil, daß sie im Gegensatz zu den marktgängigen Niederdruckpreßmassen relativ einfach auch in anderer Beziehung einstellbar sind, beispielsweise in bezug auf Wärmeleitfähigkeit, die Wärmeausdehnung, die elektrischen Isolationswerte, die Flammenwidrigkeit oder auch die Feuchtempfindlichkeit. Würde man viele dieser Füllstoffe in Niederdruckpreßmassen einbringen, so wären sie nicht mehr genügend fließfähig. Die teigartigen Polyesterharze gemäß der Erfindung sind hiervon weniger beeinflußt, da sie bei Raumtemperaturen eine relativ niedrige Viskosität haben, die bei höhergehender Temperatur noch besser wird, d.h. sie werden noch fließfähiger und die Bauteile werden besser umflossen.

Das Verfahren zum Einbringen der Massen gemäß der Erfindung wird bei sehr geringem Druck oder drucklos vorgenommen, beispielsweise 2,0 bis 20 kg. Es ist möglich, die Bauteile in einem Gehäuse unterzubringen, das mit der Preßmasse ausgefüllt wird, so daß die Lage der Baugruppe innerhalb des Gehäuses von untergeordneter Bedeutung ist. Soll das Hüllmaterial jedoch gleichzeitig das Gehäuse formen, so ist es wichtig, daß das die Bauteilegruppe haltende Teil mit der Preßmasse eine homogene, geschlossene, wasserdichte, gleichartige Oberfläche bildet. Dies kann auf einfache Weise dadurch erreicht werden, daß ein Halterungsteil für die Bauteile zum Einlegen in eine Preßform vorgesehen ist, das aus einem mit der Preßmasse getränkten, schwer kompressiblen Trägervlies oder Trägergewebe besteht.

Werkstoffe für solche Halterungsteile sind unter der Bezeichnung PREPREG an sich bekannt.

Durch die Erfindung ist somit eine Umhüllung für elektrische oder elektronische Baugruppen geschaffen worden, die durch vielseitige Einstellung im teigartigen Zustand der Preßmasse auch in bezug auf unterschiedliche Ausdehnungskoeffizienten von Bauteilen und Preßmasse den gewünschten Erfordernissen angepaßt werden kann, so daß Unterbrechungen bei den Verbindungen der Bauteile ausgeschlossen sind, ohne hierbei einen erheblichen Aufwand treiben zu müssen. Die gegebenenfalls notwendigen Kühlungen können in bisher vorhandenen und üblichen Geräten vorgenommen werden.

2 Patentansprüche

Patentansprüche

1. Isolierstoffumhüllte Bauteilegruppe mit elektronischen oder elektrischen Bauteilen, d a d u r c h g e k e n n z e i c h n e t , daß die Isolierstoffumhüllung aus vor reaktiver Aushärtung noch fließfähiger oder teigartiger, ungesättigter Polyesterharzmasse besteht, deren Temperatur-Härteniveau auf ca. 80°C eingestellt ist.

2. Bauteilegruppe nach Anspruch 1, d a d u r c h g e k e n n z e i c h n e t , daß ein Halterungsteil für die Bauteile in einer Preßform vorgesehen ist, das aus einem mit der Masse getränkten, schwer kompressiblen Trägervlies oder Trägergewebe besteht.

# EUROPÄISCHER RECHERCHENBERICHT

0078459

| | EINSCHLÄGIGE DOKUMENTE | | EP 82109735.9 |
|---|---|---|---|

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| Y | <u>DD - A - 109 112</u> (DORENDORF et al.) <br> * Anspruch 1 * <br><br> -- | 1 | H 05 K 13/00 <br> H 01 B 3/42 |
| Y | <u>DE - B - 1 290 338</u> (SCHOLVEN-CHEMIE) <br> * Beispiele 2,4; Fig. 2,4 * <br><br> -- | 1 | |
| Y | <u>US - A - 3 553 291</u> (FRIEDMAN et al.) <br> * Tabelle II * <br><br> ---- | 1 | |

| RECHERCHIERTE SACHGEBIETE (Int. Cl. 3) |
|---|
| H 05 K 13/00 |
| H 01 B 3/00 |
| C 08 L 67/00 |
| C 08 K 5/00 |
| C 08 J 3/00 |
| H 01 L 21/00 |
| H 01 L 23/00 |
| H 01 L 49/00 |
| H 01 C 1/00 |
| H 01 C 17/00 |

Der vorliegende Recherchenbericht wurde für alle Patentansprüche erstellt.

| Recherchenort | Abschlußdatum der Recherche | Prüfer |
|---|---|---|
| WIEN | 27-01-1983 | KUTZELNIGG |